# DEMANDE DE BREVET EUROPEEN

(11) **EP 4 819 107 A1**
(43) Date de publication de la demande: **07.10.2026**
(21) Numéro de dépôt: 26169251.1
(22) Date de dépôt: 30.03.2026
(51) Int. Cl.: G08G 5/22, G08G 5/32, G08G 5/34, G08G 5/53, G08G 5/56, G08G 5/72, G08G 5/76

(54) **DISPOSITIF ÉLECTRONIQUE ET PROCÉDÉ D'AIDE À LA PLANIFICATION ET À LA NÉGOCIATION DYNAMIQUE DE PLAN(S) DE VOL D'AÉRONEF(S)**

(30) Priorité: 31.03.2025 FR 2503319
(71) Demandeur: THALES, 92190 Meudon (FR)
(72) Inventeur: BLANQUÉ, Alaric, 33700 MERIGNAC (FR); BERTHELOT, Bastien, 33700 MERIGNAC (FR); LATGÉ, Dominique, 31100 TOULOUSE (FR); MICHEL, François, 33700 MERIGNAC (FR); KESSEDJIAN, Annelaure, 33700 MERIGNAC (FR)
(74) Mandataire: Lavoix

(57) **Abrégé**

La présente invention concerne un dispositif (10) électronique d'aide à la planification et à la négociation dynamique de plan(s) de vol d'aéronef(s), par connexion, de machine à machine, avec un premier et deuxième jumeaux numériques (12, 14) représentatifs respectivement d'un prestataire de services de navigation aérienne, et d'un agent d'opération aérienne, comprenant :
- un module (16) d'acquisition de données à impact sur la planification et la négociation de plan(s) de vol ;
- un module (18) d'optimisation des routes aéronautiques ;
- un module (20) de génération, à l'échelle mondiale, d'une prédiction de trafic aérien ;
- un module (22) de mise à jour desdites routes aéronautiques et prédiction de trafic;
- un module (24) de négociation de plan(s) de vol entre lesdits jumeaux numériques, en utilisant ladite prédiction de trafic.

## Description

La présente invention concerne un dispositif électronique d'aide à la planification et à la négociation dynamique de plan(s) de vol d'aéronef(s).

L'invention concerne également un procédé d'aide à la planification et à la négociation dynamique de plan(s) de vol d'aéronef(s).

L'invention concerne également un programme d'ordinateur comportant des instructions logicielles qui, lorsqu'elles sont exécutées par un ordinateur, mettent en œuvre un tel procédé.

L'invention se situe dans le domaine technique du transport aérien et plus particulièrement de la collaboration entre acteurs du trafic aérien lors de la planification des vols.

Dans l'état de la technique les acteurs du trafic aérien agissent le plus souvent indépendamment les uns des autres ou en collaborant de manière perfectible.

D'un côté, les prestataires de services de navigation aérienne ANSP (de l'anglais *Air Navigation Service Provider*) font face à plusieurs défis, à savoir :
- l'information sur le trafic aérien dans leur zone, qui souvent reçue trop tard, notamment environ trois heures avant l'heure de départ d'un vol (ou plus précisément l'heure estimée de repoussage EOBT de l'anglais *estimated off block time*)*,* limite leur capacité à anticiper ;
- l'absence d'outil de collaboration efficace entre les prestataires de services de navigation aérienne ANSP, ceux-ci se limitant le plus souvent à l'utilisation de la messagerie de l'organisation de l'aviation civile internationale OACI (ICAO de l'anglais *International civil Aviation Organization*) et du téléphone pour la gestion et la planification ;
- l'absence de référence unique et actualisée concernant les vols, ce qui crée un manque de "vérité unique" sur l'état réel du trafic aérien (i.e. un manque de vérité commune à tout le monde c'est-à-dire une estimation de l'état du trafic basée sur une donnée impartiale validée par l'ensemble des acteurs du trafic aérien) ;
- l'absence de suivi des plannings réalisés par les contrôleurs aériens ATCOs de l'anglais *Air Traffic Controleurs*)*,* et
- la discontinuité entre le ou les gestionnaire(s) des flux de trafic aérien FMP (de l'anglais *Flow Management Position*) et les contrôleurs aériens ATCOs concernant la gestion globale du flux.

Les agents d'opération aérienne, également appelés dispatchers de compagnies aériennes, font également face à d'autres difficultés à savoir :
- un manque d'efficacité dans l'intégration d'information telle qu'une fermeture de piste ou de données de gestion de trafic aérien ATM (de l'anglais *Air Trafic Management*) ce qui réduit leur capacité à anticiper et les surcharge avec des alertes, si bien que la gestion des problèmes devient prioritaire sur la planification, entraînant une cascade de difficultés non anticipées ;
- une improvisation, souvent récurrente de plans de vol, en raison de contraintes imposées par le contrôle aérien ATC (de l'anglais *Air Trafic Control*) et par la météo, ce qui complique la prévision du carburant nécessaire ;
- une mauvaise coordination avec les prestataires de services de navigation aérienne ANSP à vision locale, obligeant les compagnies aériennes, à vision globale, à fournir des solutions globales adaptées localement ;
- le temps nécessaire pour établir un plan de vol, particulièrement pour les long-courriers, souvent très long, par exemple de l'ordre de 45 minutes, ce qui ajoute une complexité supplémentaire.

A l'heure actuelle, il n'existe aucune solution capable d'agréger efficacement, en planification, et ce à l'échelle globale mondiale, les contraintes des prestataires de services de navigation aérienne ANSP ainsi que les données tangibles et non tangibles des compagnies aériennes, tout en tenant compte des particularités des espaces aériens dans le monde entier.

La présente invention a pour objectif de résoudre ce problème et de proposer une solution permettant de planifier efficacement les vols en intégrant tout au long de la planification une négociation efficace et dynamique entre les différents acteurs du trafic aérien.

A cet effet, l'invention a pour objet un dispositif électronique d'aide à la planification et à la négociation dynamique de plan(s) de vol d'aéronef(s), par connexion, de machine à machine, avec un premier jumeau numérique représentatif d'au moins un prestataire de services de navigation aérienne, et avec un deuxième jumeau numérique représentatif d'au moins un agent d'opération aérienne, ledit dispositif comprenant au moins :
- un module d'acquisition, d'analyse et de mise à jour configuré pour acquérir, analyser et mettre à jour des données, provenant d'une pluralité de sources distinctes comprenant au moins lesdits jumeaux numériques, lesdites données étant propres à avoir un impact sur la planification et la négociation de plan(s) de vol ;
- un module de création et d'optimisation configuré, à partir desdites données, pour créer et optimiser des routes aéronautiques compatibles avec les contraintes de contrôle de trafic aérien associées auxdites données ;
- un module de génération configuré pour générer, à l'échelle mondiale, au moins une prédiction de trafic aérien à partir desdites routes aéronautiques ;
- un module de mise à jour configuré pour mettre à jour lesdites routes aéronautiques et ladite au moins une prédiction de trafic aérien, dès qu'au moins une nouvelle donnée est acquise ou dès qu'au moins une donnée est mise à jour ;
- un module de négociation configuré pour intervenir, en phase de planification de plan(s) de vol, dans une négociation de plan(s) de vol entre lesdits jumeaux numériques, en utilisant ladite prédiction de trafic aérien.

La présente invention permet ainsi de simuler, en planification, au fur et à mesure du temps et des mises à jour, des scénarios de trafic aérien servant de base de négociation.

En effet, le dispositif électronique d'aide à la planification et à la négociation dynamique de plan(s) de vol d'aéronef(s) proposé selon la présente invention, joue le rôle central de passerelle (i.e. plateforme) de négociation machine-machine entre deux mondes distincts, à savoir d'une part les prestataires de services de navigation aérienne ANSP, et d'autre part les agents d'opération aérienne, et également de passerelle entre la phase stratégique de planification de vol, jusqu'à six mois avant chaque vol, et la gestion en temps réel du flux aérien, facilitant la transition entre la prévision et l'exécution des vols.

Grâce à son intégration machine-machine entre les compagnies aériennes et les fournisseurs (i.e. prestataires) de service de navigation aérienne ANSP, le dispositif électronique d'aide à la planification et à la négociation dynamique de plan(s) de vol d'aéronef(s) proposé selon la présente invention est un outil central qui permet une automatisation (au moins partielle), un suivi, et une amélioration de l'efficacité du processus de planification et de négociation, offrant des alternatives fiables et réduisant la charge de travail des ANSP les fournisseurs de service de navigation aérienne NSP en cas de nouvelles contraintes ou d'ajustements nécessaires.

Suivant d'autres aspects avantageux de l'invention, le dispositif électronique d'aide à la planification et à la négociation dynamique de plan(s) de vol d'aéronef(s) comprend une ou plusieurs des caractéristiques suivantes, prises isolément ou suivant toutes les combinaisons techniquement possibles :
- lesdites données comprennent des données fournies par lesdits jumeaux numériques et également des données de contexte de type appartenant au groupe comprenant au moins :
   - des données de surveillances fournie par un système de surveillance coopératif pour le contrôle du trafic aérien ;
   - des publications aéronautiques ;
   - des données météorologiques ;
   - des données d'évènements ;
   - des données historiques ;
- ledit module de négociation comprend au moins :
   - une première entité d'interaction avec le premier jumeau numérique représentatif d'au moins un prestataire de services de navigation aérienne, au moins configurée pour recevoir au moins une information représentative d'une capacité dudit au moins un prestataire de services de navigation aérienne, ladite capacité étant définie pour chaque zone de contrôle de l'espace aérien associé audit au moins un prestataire de services de navigation aérienne et pour une période temporelle prédéterminée ;
   - une deuxième entité d'interaction avec le deuxième jumeau numérique représentatif d'au moins un agent d'opération aérienne, au moins configurée pour recevoir au moins une information représentative d'une demande dudit au moins un agent d'opération aérienne, ladite demande étant définie par les vols prévus ou en cours associés audit au moins un agent d'opération aérienne ;
   - une entité de détermination d'éléments d'aide à la négociation configurée au moins pour:
      - déterminer, pour chaque prestataire de services de navigation aérienne, une information de demande d'intérêt représentative de tous les vols traversant une de ses zones de contrôle ;
      - déterminer, pour chaque agent d'opération aérienne, une information de capacité d'intérêt regroupant les capacités des zones traversées ;
- l'entité de détermination est également configurée pour estimer l'évolution de la demande de trafic en utilisant :
   - un filtrage optimal appartenant au groupe comprenant :
   - un filtrage de Kalman ;
   - un filtrage particulaire ;
      ou
   - un apprentissage machine prédéterminé ;
- ladite entité de détermination d'éléments d'aide à la négociation est en outre configurée pour:
   - déterminer, par recherche dans une base de données de situation(s) similaire(s) à la situation courante, pour chaque prestataire de services de navigation aérienne, une solution de capacité représentative de la capacité permettant d'absorber au mieux la demande d'intérêt ;
   - déterminer, pour chaque agent d'opération aérienne, une solution de demande proposant au moins un vol compatible avec la capacité d'intérêt, en utilisant un algorithme prédéterminé de recherche de chemin et une pondération prédéterminée basée sur au moins une intention de mise en œuvre de vol dudit agent d'opération aérienne.
- ledit module de négociation est en outre configuré pour rendre la négociation autonome en appliquant un ensemble de règles prédéterminées de traitement de ladite solution de capacité et/ou de ladite solution de demande proposée(s) ;
- la solution de demande est déterminée en outre en utilisant un catalogue de routes prédéterminé et une base de règles métier propres aux compagnies aériennes, ledit catalogue et ladite base de règle métier étant préalablement configurés par ledit au moins un agent d'opération aérienne ;
- ledit module de négociation comprend en outre:
   - une entité de simulation d'au moins un autre prestataire de services de navigation aérienne non représenté par ledit premier jumeau numérique tout en participant à ladite capacité d'intérêt ;
   - une entité de simulation d'au moins un autre agent d'opération aérienne non représenté par ledit deuxième jumeau numérique tout en participant à ladite demande d'intérêt.

L'invention concerne également un procédé d'aide à la planification et à la négociation dynamique de plan(s) de vol d'aéronef(s), par connexion, de machine à machine, avec un premier jumeau numérique représentatif d'au moins un prestataire de services de navigation aérienne, et avec un deuxième jumeau numérique représentatif d'au moins un agent d'opération aérienne, ledit procédé étant mis en œuvre par un dispositif électronique d'aide à la planification et à la négociation dynamique de plan(s) de vol,
ledit procédé comprenant au moins une itération des étapes suivantes :
- acquisition, analyse et/ou mise à jour de données, provenant d'une pluralité de sources distinctes comprenant au moins lesdits jumeaux numériques, lesdites données étant propres à avoir un impact sur la planification et la négociation de plan(s) de vol ;
- création et optimisation de routes aéronautiques compatibles avec les contraintes de contrôle de trafic aérien associées auxdites données ;
- génération, à l'échelle mondiale, d'au moins une prédiction de trafic aérien à partir desdites routes aéronautiques ;
- mise à jour desdites routes aéronautiques et de ladite au moins une prédiction de trafic aérien, dès qu'au moins une nouvelle donnée est acquise ou dès qu'au moins une donnée est mise à jour ;
- intervention, en phase de planification de plan(s) de vol, dans une négociation de plan(s) de vol entre lesdits jumeaux numériques, en utilisant ladite prédiction de trafic aérien.

L'invention concerne également un programme d'ordinateur comportant des instructions logicielles qui, lorsqu'elles sont exécutées par un ordinateur, mettent en œuvre un procédé de d'aide à la planification et à la négociation dynamique de plan(s) de vol d'aéronef(s) tel que défini ci-dessus.

L'invention apparaîtra plus clairement à la lecture de la description qui va suivre, donnée uniquement à titre d'exemple non limitatif, et faite en référence aux dessins dans lesquels :
- [Fig. 1] la figure 1 est une vue schématique d'un dispositif électronique d'aide à la planification et à la négociation dynamique de plan(s) de vol d'aéronef(s) selon la présente invention ;
- [Fig. 2] la figure 2 est une vue schématique illustrant, au cours du temps, les interactions, de machine à machine, d'un dispositif électronique d'aide à la planification et à la négociation dynamique de plan(s) de vol d'aéronef(s) selon la présente invention, avec un premier jumeau numérique représentatif d'au moins un prestataire de services de navigation aérienne, et avec un deuxième jumeau numérique représentatif d'au moins un agent d'opération aérienne ;
- [Fig. 3] la figure 3 est un organigramme d'un procédé d'aide à la planification et à la négociation dynamique de plan(s) de vol d'aéronef(s) selon la présente invention mis en œuvre par le dispositif de la figure 1 ; et
- [Fig.4] [Fig.5] les figures 4 et 5 sont différentes vues illustrant des étapes optionnelles du procédé d'aide à la planification et à la négociation dynamique de plan(s) de vol d'aéronef(s) de la figure 3, selon un mode de négociation dite autonome.

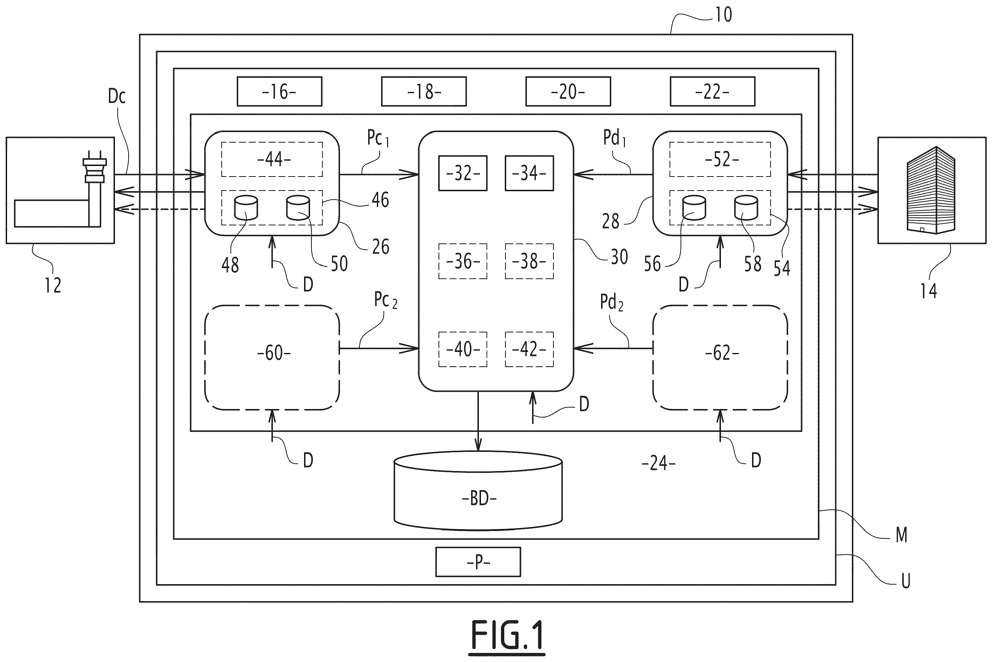

La figure 1 illustre schématiquement un exemple non limitatif d'un dispositif électronique 10 d'aide à la planification et à la négociation dynamique de plan(s) de vol d'aéronef(s) selon la présente invention.

Selon cet exemple de réalisation, le dispositif 10 électronique d'aide à la planification et à la négociation dynamique de plan(s) de vol d'aéronef(s) est propre à être connecté, machine à machine, à un premier jumeau numérique 12 représentatif d'au moins un prestataire de services de navigation aérienne ANSP (de l'anglais *Air Navigation Service Provider*) d'une part, et d'autre part à un deuxième jumeau numérique 14 représentatif d'au moins un agent d'opération aérienne (i.e. également appelé dispatcher de compagnie aérienne).

Le dispositif électronique 10 d'aide à la planification et à la négociation dynamique de plan(s) de vol d'aéronef(s) selon la présente invention comprend tout d'abord un module 16 d'acquisition, d'analyse et de mise à jour configuré pour acquérir, analyser et mettre à jour des données, provenant d'une pluralité de sources distinctes comprenant au moins lesdits jumeaux numériques, lesdites données étant propres à avoir un impact sur la planification et la négociation de plan(s) de vol.

Le dispositif électronique 10 d'aide à la planification et à la négociation dynamique de plan(s) de vol d'aéronef(s) selon la présente invention comprend également un module 18 de création et d'optimisation configuré, à partir desdites données, pour créer et optimiser des routes aéronautiques compatibles avec les contraintes de contrôle de trafic aérien.

A noter que par route aéronautique, on entend par la suite un vol défini par un aéroport de départ et un aéroport d'arrivée, une route étant une version simplifiée d'un plan de vol qui lui est associé à un aspect juridique portant sur la trajectoire utilisée à une date précise et à un aspect temporel lié à la date et au créneau du vol.

Autrement dit, le module 18 de création et d'optimisation est configuré pour créer automatiquement, au plus tôt, des routes optimisées compatibles avec les contraintes ATC (de l'anglais *Air Trafic Control*)*,* et susceptibles d'être empruntées par les compagnies aériennes. Le niveau de détail des routes proposées évolue avec les informations mises à niveau dans le temps : contraintes ANSP, activités militaires, messages aux navigants aérien NOTAMs (de l'anglais *Notice to Airmen*)*,* prévisions météorologiques pour aller vers la définition d'une trajectoire 4D (i.e. en quatre dimensions comprenant trois dimensions spatiales et une dimension temporelle).

Le dispositif électronique 10 d'aide à la planification et à la négociation dynamique de plan(s) de vol d'aéronef(s) selon la présente invention comprend également un module 20 de génération configuré pour générer, à l'échelle mondiale, au moins une prédiction de trafic aérien à partir desdites routes aéronautiques.

Autrement dit, un tel module 20 fournit une vue d'ensemble (i.e. une vue complète) du trafic aérien à venir, permettant de simuler des scénarios et d'ajuster les contraintes sectorielles en fonction des prévisions, tout en offrant des indicateurs clés de performance KPI (de l'anglais *key performance indicator*) pour gérer les points chauds. Une telle simulation du trafic aérien à venir sert de base de négociation en phase de planification.

Le dispositif électronique 10 d'aide à la planification et à la négociation dynamique de plan(s) de vol d'aéronef(s) selon la présente invention comprend en outre un module 22 de mise à jour configuré pour mettre à jour lesdites routes aéronautiques et ladite au moins une prédiction de trafic aérien, dès qu'au moins une nouvelle donnée est acquise ou dès qu'au moins une donnée est mise à jour.

Le dispositif électronique 10 d'aide à la planification et à la négociation dynamique de plan(s) de vol d'aéronef(s) selon la présente invention comprend également un module 24 de négociation configuré pour intervenir, en phase de planification de plan(s) de vol, dans une négociation de plan(s) de vol entre lesdits jumeaux numériques, en utilisant ladite prédiction de trafic aérien.

Autrement dit, la prédiction du trafic aérien planifié est utilisée comme support de négociation à la planification.

Dans l'exemple de la figure 1, le dispositif électronique d'aide à la planification et à la négociation dynamique de plan(s) de vol d'aéronef(s) comprend une unité U de traitement d'informations formée par exemple d'une mémoire M et d'un processeur P associé à la mémoire M.

Dans l'exemple de la figure 1, le module 16 d'acquisition, d'analyse et de mise à jour, le module 18 de création et d'optimisation, le module 20 de génération, le module 22 de mise à jour et le module 24 de négociation, sont réalisés chacun sous forme d'un logiciel (e.g. API (de l'anglais *application programming interface*) ou encore une interface homme-machine), ou d'une brique logicielle, exécutable par le processeur P. La mémoire M du dispositif électronique 10 d'aide à la planification et à la négociation dynamique de plan(s) de vol d'aéronef(s) est alors apte à stocker un logiciel d'acquisition, d'analyse et de mise à jour, un logiciel de création et d'optimisation, un logiciel de génération, un logiciel de mise à jour et un logiciel de négociation. Le processeur P est alors apte à exécuter chacun des logiciels parmi le logiciel d'acquisition, d'analyse et de mise à jour, le logiciel de création et d'optimisation, et le logiciel de génération, le logiciel de mise à jour et le logiciel de négociation.

En variante non représentée, le module d'acquisition, d'analyse et de mise à jour, le module de création et d'optimisation, le module de génération, le module de mise à jour et le module de négociation, sont réalisés chacun sous forme d'un composant logique programmable, tel qu'un FPGA (de l'anglais *Field Programmable Gate Array*)*,* ou encore d'un circuit intégré, tel qu'un ASIC (de l'anglais *Application Specific Integrated Circuit*)*.*

Lorsque le dispositif électronique 10 d'aide à la planification et à la négociation dynamique de plan(s) de vol d'aéronef(s) est réalisé sous forme d'un ou plusieurs logiciels, c'est-à-dire sous forme d'un programme d'ordinateur, également appelé produit programme d'ordinateur, il est en outre apte à être enregistré sur un support, non représenté, lisible par ordinateur. Le support lisible par ordinateur est par exemple un medium apte à mémoriser des instructions électroniques et à être couplé à un bus d'un système informatique. A titre d'exemple, le support lisible est un disque optique, un disque magnéto-optique, une mémoire ROM, une mémoire RAM, tout type de mémoire non-volatile (par exemple FLASH ou NVRAM) ou une carte magnétique. Sur le support lisible est alors mémorisé un programme d'ordinateur comprenant des instructions logicielles.

En complément facultatif, ledit module 24 de négociation comprend au moins : une première entité 26 d'interaction avec le premier jumeau numérique représentatif d'au moins un prestataire de services de navigation aérienne (également appelée agent ANSP), une deuxième entité 28 d'interaction avec le deuxième jumeau numérique représentatif d'au moins un agent d'opération aérienne (également appelée agent compagnie aérienne), et une entité 30 de détermination d'éléments d'aide à la négociation.

Selon ce complément facultatif, la première entité 26 d'interaction avec le premier jumeau numérique 12 représentatif d'au moins un prestataire de services de navigation aérienne, est au moins configurée pour recevoir au moins une information Dc représentative d'une capacité dudit au moins un prestataire de services de navigation aérienne, ladite capacité étant définie pour chaque zone de contrôle de l'espace aérien associé audit au moins un prestataire de services de navigation aérienne et pour une période temporelle prédéterminée.

Par exemple, une telle capacité est le nombre de secteurs dans la zone de contrôle de l'espace aérien associé audit au moins un prestataire de services de navigation aérienne, et/ou correspond aux contraintes associées à ladite zone : point de passage, zone interdite, altitude maximum, etc..., et/ou correspond à des intentions et priorités prédéterminées dudit au moins un prestataire de services de navigation aérienne.

La première entité 26 d'interaction avec le premier jumeau numérique est en outre propre à compléter les prévisions de capacités au moyen de données de contexte D par exemple acquises par le module d'acquisition 16, et à fournir une prévision de capacité Pc₁ à l'entité 30 de détermination d'éléments d'aide à la négociation.

De telles données de contexte D sont de type appartenant au groupe comprenant au moins :
- des données de surveillances fournie par un système de surveillance coopératif pour le contrôle du trafic aérien ;
- des publications aéronautiques ;
- des données météorologiques ;
- des données d'évènements ;
- des données historiques ;
- etc.

Les données de surveillance sont par exemple fournies par des fournisseurs de données ADS-B (de l'anglais *Automatic dependent surveillance-broadcast*) tel que le système de surveillance coopératif pour le contrôle du trafic aérien « Flight Radar 24 », le système de Metron Aviation, etc., et correspondant à l'ensemble des données ADS-B émises par les aéronefs, soit en temps réel, soit à des données historiques.

Les données de publications aéronautiques sont par exemple fournies par des prestataires de services de navigation aérienne ANSP, par des aéroports, par une organisation pour la sécurité de la navigation aérienne telle qu'EUROCONTROL par exemple, et correspondent à l'ensemble des documents, publications de site web diffusés par ces acteurs.

Les données météorologiques sont fournies par des fournisseurs de prévision météorologiques et correspond à des prévisions météo.

Les données d'évènements sont par exemple fournies via Internet, via les journaux, etc., et correspondent à des évènements ayant un impact sur la planification et la négociation dynamique de plan(s) de vol, tels qu'une grève de contrôleurs ou de personnels aéroportuaires, des évènements sportifs majeurs, etc.

Selon ce complément facultatif, la deuxième entité 28 d'interaction avec le deuxième jumeau numérique 14 représentatif d'au moins un agent d'opération aérienne, est au moins configurée pour recevoir au moins une information représentative d'une demande dudit au moins un agent d'opération aérienne (représentée par la flèche allant du deuxième jumeau numérique 14 à ladite deuxième entité 28 d'interaction), ladite demande étant définie par les vols prévus ou en cours (les vols en cours permettant de mettre à jour la prédiction de trafic pour les vols qui arrivent (i.e. qui vont bientôt débuter)), associés audit au moins un agent d'opération aérienne (i.e. également appelé dispatcher de compagnie aérienne), un vol pouvant être représenté par les aéroports de départ, de destinations et les horaires du vol, l'ensemble de routes que peut prendre le vol, le plan de vol, les intentions et priorités attachés à ce vol (i.e. le ou les plans de vol pour les compagnies aériennes et le ou les plan(s) de sectorisation/stratégie de déconfliction côté ANSP), etc.

La deuxième entité 28 d'interaction avec le deuxième jumeau numérique 14 représentatif d'au moins un agent d'opération aérienne est en outre propre à compléter les prévisions de demande au moyen de données de contexte D par exemple acquises par le module d'acquisition 16 (de type tel que précité en relation avec la première entité 26), et à fournir une prévision de demande Pd₁ à l'entité 30 de détermination d'éléments d'aide à la négociation.

Autrement dit, les prévisions de capacité Pc₁ et de demande Pd₁ sont des estimations basées sur des situations similaires passées.

Toujours selon ce complément facultatif, l'entité 30 de détermination d'éléments d'aide à la négociation comprend, selon un premier mode de négociation dite « basique », un premier outil 32 configuré pour déterminer, pour chaque prestataire de services de navigation aérienne, une information de demande d'intérêt représentative de tous les vols traversant une de ses zones de contrôle, et un deuxième outil 34 configuré pour déterminer, pour chaque agent d'opération aérienne, une information de capacité d'intérêt regroupant les capacités des zones traversées, par un ou plusieurs vols.

Par exemple, une information de demande d'intérêt peut être représentée par un ensemble de flux, une liste de vols et/ ou des points chauds, un point chaud étant une zone de l'espace aérien où il y a un risque pour l'efficacité des opérations aériennes (météo imprévue, congestion autour d'un aéroport, problème sur un aéroport, problème géopolitique...).

Plus précisément, l'entité 30 de détermination d'éléments d'aide à la négociation, via les outils 32 et 34 respectivement est propre à fusionner toutes les prévisions pour calculer les demandes et les capacités d'intérêts selon des traitements basiques connus à savoir que les prévisions de demande passant par une zone de contrôle vont fusionner pour établir une demande d'intérêt, et les prévisions de capacité sur des zones traversées par une demande vont fusionner pour établir une capacité d'intérêt.

Toutes ces demandes et capacités d'intérêt sont stockées dans une base de données BD.

Le traitement de fusion mis en œuvre par ladite entité 30 de détermination d'éléments d'aide à la négociation, via les outils 32 et 34 est propre à être déclenché de deux manières, à savoir, synchrone selon une période de temps prédéterminée (par exemple toutes les heures), ou asynchrone à chaque changement de capacité et/ou de demande fournis ou si un évènement dans le contexte arrive. En effet, les données d'évènements sont propres à avoir un impact sur la demande ou la capacité.

A noter que les données de contexte sont propres à comprendre des données autres que celles précitées de surveillance, de publications aéronautiques, météorologiques, d'évènements, telles que toute donnée pouvant aider la définition des capacités et de la demande, à savoir par exemple d'autres données fournies par chaque prestataire de services de navigation aérienne ANSP, par chaque agent d'opération aérienne (i.e. compagnie aérienne), par les aéroports, correspondant à des plans de vol déposés chez les prestataires de services de navigation aérienne ANSP, des données historiques, etc.

Autrement dit, dans un tel premier mode de négociation dite « basique », le dispositif électronique d'aide à la planification et à la négociation dynamique de plan(s) de vol d'aéronef(s) selon la présente invention (également appelé passerelle ou encore plateforme) fournit à chaque prestataire de services de navigation aérienne ANSP connecté, de machine à machine, via le premier jumeau numérique 12, sa demande d'intérêt, c'est-à-dire, les prévisions de trafic pour la zone de contrôle dudit ANSP considéré. De même, le dispositif électronique d'aide à la planification et à la négociation dynamique de plan(s) de vol d'aéronef(s) fournit à chaque agent d'opération aérienne (i.e. compagnie aérienne), via le deuxième jumeau numérique 14, sa capacité d'intérêt, c'est-à-dire les prévisions de capacité pour ses vols.

Ces données, à savoir demande d'intérêt et capacité d'intérêt, permettent aux différents acteurs connectés au dispositif électronique 10 d'aide à la planification et à la négociation dynamique de plan(s) de vol d'aéronef(s) selon la présente invention de négocier, selon ce mode de négociation dite « basique ».

Selon ce mode de négociation dite « basique », le dispositif électronique 10 d'aide à la planification et à la négociation dynamique de plan(s) de vol d'aéronef(s) selon la présente invention est propre à mettre en œuvre :
- des modèles (algorithmiques) dits "experts" ou « fondés sur des règles » (de l'anglais *"rule-based"*) correspondant à des fonctions mathématiques ou des règles fondées sur des connaissances a priori ; et/ou
- des modèles (algorithmiques) fondés sur les données (de l'anglais « data-driven ») ou d'apprentissage machine (de l'anglais *machine learning*) correspondant à des algorithmes machines entrainés à reconnaitre des situations qui se seraient déjà produites. Ces modèles reposent sur des méthodes d'analyse statistique et d'apprentissage machine supervisé ou non.

A noter que les prestataires de services de navigation aérienne connectés via le premier jumeau numérique 12 et les agent d'opération aérienne connectés via le deuxième jumeau numérique 14 sont en permanence notifiés des changements sur leurs capacités ou demande d'intérêts et peuvent donc les consulter.

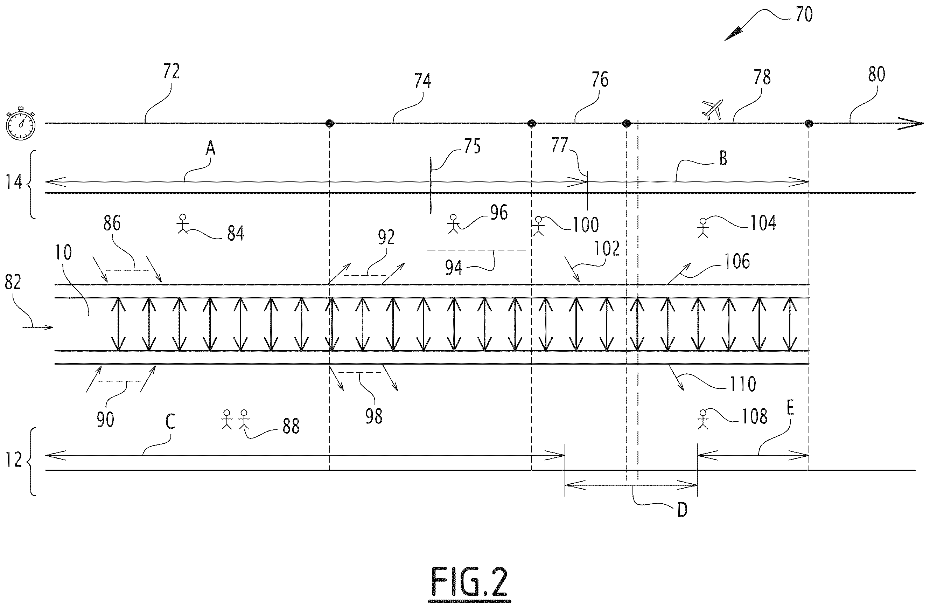

Comme illustré par la suite, notamment en relation avec la figure 2, ayant ces informations, les prestataires de services de navigation aérienne ANSPs et agents d'opération aérienne (i.e. compagnies aériennes) peuvent adapter respectivement leurs capacités et demandes.

En complément facultatif, l'entité 30 de détermination d'éléments d'aide à la négociation est également configuré pour estimer l'évolution de la demande de trafic en utilisant un filtrage 40 optimal appartenant au groupe comprenant notamment un filtrage de Kalman, un filtrage particulaire, etc., ou en utilisant un apprentissage machine 42 prédéterminé.

Pour ce faire, la demande de trafic est par exemple considérée comme une série temporelle, comme le nombre d'aéronefs occupant le secteur chaque heure, qu'il est alors possible de caractériser pour en prédire l'évolution. Dans ce cas, l'entité 30 de détermination d'éléments d'aide à la négociation est alors par exemple configurée pour utiliser des méthodes de filtrage optimal comme le filtre de Kalman ou le filtre particulaire afin d'estimer l'évolution de la demande de trafic.

Pour ce faire, il est pris pour postulat que l'information de demande de trafic est une information qui évolue d'une manière connue a priori.

Dans ce contexte, on considère une variable d'état correspondant à la valeur de demande de trafic *a priori,* issue de la connaissance experte, et notée *x_{apriori,t}* à l'instant *t*, et un modèle de propagation correspondant à l'évolution de la demande de trafic en fonction du temps issu de la connaissance.

Un tel modèle de propagation est une loi connue comme, par exemple, une fonction linéaire par morceaux selon la période de l'année ou le jour de la semaine, ou encore une fonction plus complexe dépendant de facteurs tels que le type d'aéronef, la météo, l'ouverture ou fermeture de zones militaires, etc. Cette évolution peut être modélisée comme : *x_{apriori,t}* = *f*(*x*_{*apriori,t*-1}) *+ wₜ*, avec *f* la fonction de propagation, et *wₜ* appelé bruit de processus, qui correspond à l'incertitude sur l'évolution de la donnée.

À certains moments, des observations *x_{obs,t}* concernant la demande de trafic sont collectées et sujettes à une certaine erreur de mesure, notée *vₜ*.

Le filtrage particulaire repose sur un ensemble d'étapes, à savoir tout d'abord une initialisation consistant à générer un ensemble initial de particules ${\left\{{x}_{apriori , t}^{\left(i\right)}\right\}}_{i = 1}^{N}$ qui représente l'estimation initiale de la distribution de la variable d'état (niveau de demande de trafic). Chaque particule a une pondération initiale égale, par exemple ${w}_{t}^{\left(i\right)} = \frac{1}{N}$*,* avec N un entier naturel correspondant au nombre de particules, et choisi selon un compromis entre complexité calculatoire et précision.

Puis, le filtrage particulaire comprend une prédiction consistant pour chaque particule, à appliquer le modèle d'évolution pour prédire le niveau de demande de trafic au temps suivant *t.* Si $f \left({x}_{apriori , t - 1}^{\left(i\right)}\right)$ est le modèle d'évolution, la prédiction pour chaque particule devient ${x}_{BMM , t}^{\left(i\right)} = f \left({x}_{apriori , t - 1}^{\left(i\right)}\right) + {w}_{t}^{\left(i\right)}$, où ${w}_{t}^{\left(i\right)}$ est un échantillon tiré de la distribution du bruit du processus. Chaque particule se propage.

Puis, le filtrage particulaire comprend une mise à jour consistant, lors de la réception d'une nouvelle observation *x_{obs,t},* à mettre à jour les pondérations de chaque particule en fonction de la probabilité de cette observation sachant l'état prédit. Cela est souvent réalisé en calculant la densité de probabilité de *x_{obs,t}* sachant ${x}_{apriori , t}^{\left(i\right)}$ et en mettant à jour les pondérations ${w}_{t}^{\left(i\right)}$ en conséquence. La mise à jour des pondérations peut être effectuée en utilisant, par exemple, la probabilité $p \left({x}_{obs , t}\left|{x}_{apriori , t}^{\left(i\right)}\right.\right)$.

Puis, le filtrage particulaire comprend un ré-échantillonnage, pour éviter le problème de la dégénérescence des particules, où quelques particules finissent par avoir une pondération significativement plus élevée que les autres. Cela implique de sélectionner un nouveau jeu de particules à partir de l'ensemble actuel, où les particules avec une pondération plus élevée sont plus susceptibles d'être choisies.

Enfin, le filtrage particulaire comprend l'estimation en tant que telle, du niveau courant de demande de trafic propre à être calculée comme une moyenne pondérée, telle que le barycentre de la distribution des particules après la mise à jour, soit ${\hat{x}}_{apriori , t} = {\sum }_{i = 1}^{N} {w}_{t}^{\left(i\right)} {x}_{apriori , t}^{\left(i\right)}$ .

Ainsi, les données de demande de trafic collectées en opération permettent de mettre à jour le modèle de propagation de demande de trafic fourni initialement par la connaissance experte.

A titre d'alternative, une autre approche consiste à entrainer un algorithme de d'apprentissage machine visant à estimer la demande de trafic. Dans ce cas, un ensemble de données pertinentes est collecté. Les données sont considérées pertinentes dans le sens où elles corrélèrent avec la demande de trafic.

Des signaux sont également propres à être considérés, comment des trajectoires, l'évolution de facteurs météorologiques, etc. Ces signaux sont ensuite utilisés en entrée d'un "modèle" qui vise à estimer la demande de trafic.

Ce modèle est propre à reposer d'une part sur des méthodes d'apprentissage profond, mais aussi sur la combinaison de techniques de traitement du signal et d'apprentissage machine.

Selon une première option, la sélection de marqueurs discriminants est effectuée par l'apprentissage machine sans sélection a priori. Selon une deuxième option, des traitements du signal sont mis en œuvre pour extraire des « caractéristiques » (de l'anglais *features*) ou « signatures » à partir des processus collectés. Puis, un classifieur, fondé sur de l'apprentissage machine, utilise ces signatures afin de fournir une décision sur la demande de trafic.

De telles caractéristiques sont propres à être issues d'une analyse fréquentielle du signal, mais aussi d'une analyse temps-fréquence ou temporelle.

Pour l'analyse fréquentielle, les signatures pertinentes sont généralement la valeur de puissance portée par des bandes de fréquence, ou bien des rapports de puissance.

Dans une analyse temporelle, on s'intéresse généralement à des grandeurs telles que la moyenne du signal, sa puissance, le taux de passage à zéro ou encore les paramètres d'un modèle a priori. Il s'agit alors de modéliser la manière dont les échantillons du signal sont liés les uns aux autres, et d'en déduire les paramètres du modèle associé. D'autres types de caractéristiques sont liés à la régularité du signal, qui peut être vue comme la propension au chaos. Ces techniques peuvent reposer sur l'analyse entropique comme l'entropie de Shannon, l'entropie spectrale, l'entropie approximée, la dimension fractale d'Higuchi, ou encore l'analyse entropique multi-échelle.

Dans le cas où le signal est dit monofractal, des techniques comme l'analyse des fluctuations redressées, permettent d'estimer une grandeur, appelée le coefficient de Hurst, qui caractérise la régularité globale d'un signal. Ces paramètres sont ensuite utilisés en entrée d'un apprentissage aléatoire par exemple de type « forêt aléatoire » (de l'anglais *random forest*) entrainé à associer un jeu de paramètres à une demande de trafic.

A noter que pour estimer l'évolution de la demande de trafic, une solution dite « boite noire » est propre à être également pertinente. A noter que par « boite noire », on entend le fait d'estimer la demande de trafic, représentée par un nombre d'aéronefs entrant dans un secteur par heure, en fonction de cette même donnée dans le passé (i.e. la demande de trafic est vue comme une série temporelle). Différemment, dans un système « boîte blanche », on chercherait à connaitre chaque trajectoire ou chaque phénomène ayant un impact sur le fait qu'un vol passe réellement par un secteur (météo, zone militaire, etc.) pour l'intégrer dans le nombre d'aéronefs.

Selon un deuxième mode de négociation dite « sollicitée », l'entité 30 de détermination d'éléments d'aide à la négociation comprend un troisième outil optionnel 36 configuré pour déterminer, par recherche dans une base de données de situation(s) similaire(s) à la situation courante, pour chaque prestataire de services de navigation aérienne, une solution de capacité représentative de la capacité permettant d'absorber au mieux la demande d'intérêt. Une solution de capacité correspond par exemple à un ensemble de contraintes de réacheminement (de l'anglais *rerouting*)*.*

Toujours selon ce deuxième mode de négociation dite « sollicitée », l'entité 30 de détermination d'éléments d'aide à la négociation comprend un quatrième outil optionnel 38 configuré pour déterminer, pour chaque agent d'opération aérienne, une solution de demande proposant au moins un vol compatible avec la capacité d'intérêt, en utilisant un algorithme prédéterminé de recherche de chemin et une pondération prédéterminée basée sur au moins une intention de mise en œuvre de vol dudit agent d'opération aérienne. Une solution de demande correspond à un réacheminement (de l'anglais *rerouting*) compatible avec des zones interdites le long de la route considérée.

Autrement dit, dans un tel second mode de négociation dite « sollicitée », le dispositif électronique d'aide à la planification et à la négociation dynamique de plan(s) de vol d'aéronef(s) selon la présente invention (également appelé passerelle ou encore plateforme) fournit en plus des solutions de capacité pour les prestataires de services de navigation aérienne ANSPs et des solutions de demande pour les agents d'opération aérienne (i.e. compagnies aériennes). C'est donc un mode de négociation enrichi par rapport au premier mode de négociation précité, où le dispositif 10 électronique d'aide à la planification et à la négociation dynamique de plan(s) de vol d'aéronef(s) selon la présente invention, fournit des solutions de capacité ou de demande que, respectivement, les ANSPs ou les compagnies aériennes peuvent adopter.

Ainsi, le dispositif 10 électronique d'aide à la planification et à la négociation dynamique de plan(s) de vol d'aéronef(s) selon la présente invention détermine des solutions de capacité correspondant par exemple à un ensemble de contraintes pour les ANSPs permettant d'absorber une demande, et/ou des solutions de demande correspondant par exemple à des vols compatibles des contraintes et optimisés en consommation de fuel ou en temps.

Selon ce mode de négociation dite « sollicitée », le dispositif électronique d'aide à la planification et à la négociation dynamique de plan(s) de vol d'aéronef(s) selon la présente invention met en œuvre une optimisation utilisant d'abord les données de capacité et de demande et en particulier les intentions et priorités de chacun des acteurs afin d'en extraire les critères d'optimisations, puis utilisant les capacités et les demandes d'intérêt qui représentent les contraintes de l'optimisation, et enfin calculer des solutions de demande et ou de capacité en utilisant lesdits critères d'optimisations et lesdites contraintes de l'optimisation.

Selon ce mode de négociation dite « sollicitée », le dispositif électronique 10 d'aide à la planification et à la négociation dynamique de plan(s) de vol d'aéronef(s) selon la présente invention est propre à utiliser, pour déterminer des solutions (i.e. optimisations) de capacité, une base de données qui stocke des couples (demande de trafic sur la zone, meilleur solution de capacité), remplie au cours du temps par les gestionnaire(s) des flux de trafic aérien FMPs (de l'anglais *Flow Management Position*) selon leur expertise, et la solution d'optimisation consiste à rechercher des situations similaires pour trouver les meilleurs solutions de capacité.

Selon ce mode de négociation dite « sollicitée », le dispositif électronique 10 d'aide à la planification et à la négociation dynamique de plan(s) de vol d'aéronef(s) selon la présente invention est propre à utiliser, pour déterminer des solutions (i.e. optimisations) de demande, des algorithmes de type « recherche de chemin » (de l'anglais *path finding*) tel que A*, Dijsktra, etc. intégrant les contraintes des zones de contrôles traversées avec des fonctions de poids basées sur les intentions des compagnies aériennes (minimisation du fuel ou du temps de vol).

En option de ce complément facultatif, selon un troisième mode de négociation dite « autonome », le module 24 de négociation est également configuré pour rendre la négociation autonome en appliquant un ensemble de règles prédéterminées de traitement de ladite solution de capacité et/ou de ladite solution de demande proposée(s).

Autrement dit, dans un tel troisième mode de négociation dite « autonome », le dispositif électronique d'aide à la planification et à la négociation dynamique de plan(s) de vol d'aéronef(s) selon la présente invention (également appelé passerelle ou encore plateforme) va réagir au nom d'un prestataire de services de navigation aérienne ANSP et/ou d'agents d'opération aérienne (i.e. compagnie aérienne) vis-à-vis d'un changement des capacités ou des demandes d'intérêt. C'est donc un mode de négociation encore plus enrichi par rapport au deuxième mode de négociation précité.

Dans un tel troisième mode de négociation dite « autonome », la première entité 26 d'interaction avec le premier jumeau numérique représentatif d'au moins un prestataire de services de navigation aérienne comprend optionnellement un outil 44 de calcul autonome de ladite solution de capacité et utilise pour ce faire un ensemble 46 de base de données comprenant notamment une base de données 48 de contraintes possibles sur la zone d'intérêt dudit au moins un prestataire de services de navigation aérienne ANSP et une base 50 de règles métiers propres aux ANSP. Les règles métiers sont utilisées pour sélectionner automatiquement, en fonction de la demande d'intérêt, quelles sont les contraintes possibles à appliquer. La base de données de contraintes 48 et la base de règles métier 50 sont notamment configurées par ledit au moins un prestataire de services de navigation aérienne ANSP, via ledit premier jumeau numérique 12.

De plus, dans un tel troisième mode de négociation dite « autonome », la deuxième entité 28 d'interaction avec le deuxième jumeau numérique représentatif d'au moins un agent d'opération aérienne comprend optionnellement un outil 52 de calcul autonome de ladite solution de demande et utilise pour ce faire un ensemble 54 de base de données comprenant notamment une base de données 56 de routes possibles (i.e. un catalogue de routes prédéterminé) et une base 58 de règles métier propres aux compagnies aériennes. Les règles métiers de la base 58 sont utilisées pour sélectionner automatiquement les meilleures routes possibles en fonction de la capacité d'intérêt. La base de données 56 de route et la base 58 de règles métier sont configurées par ledit au moins un agent d'opération aérienne (i.e. compagnie aérienne).

En complément facultatif, ledit module de négociation 24 comprend en outre: une entité 60 de simulation d'au moins un autre prestataire de services de navigation aérienne non représenté par ledit premier jumeau numérique tout en participant à ladite capacité d'intérêt, et une entité 62 de simulation d'au moins un autre agent d'opération aérienne non représenté par ledit deuxième jumeau numérique tout en participant à ladite demande d'intérêt.

Autrement dit, selon ce complément facultatif les prestataires de services de navigation aérienne ou les agents d'opération aérienne, qui ne sont pas directement en interaction avec dispositif 10 d'aide à la planification et à la négociation dynamique de plan(s) de vol d'aéronef(s), sont simulés pour obtenir notamment une prédiction du trafic à l'échelle mondiale fiable.

Plus précisément, l'entité 60 de simulation d'au moins un autre prestataire de services de navigation aérienne ANSP non représenté par ledit premier jumeau numérique simule le comportement des ANSPs qui ne sont pas connectés au dispositif 10 d'aide à la planification et à la négociation dynamique de plan(s) de vol d'aéronef(s) mais qui participent à la capacité d'intérêt des agents d'opération aérienne (i.e. compagnies aériennes) connectés via ledit deuxième jumeau numérique.

L'entité 60 de simulation d'au moins un autre prestataire de services de navigation aérienne ANSP est en outre propre à compléter les prévisions de capacités simulées au moyen de données de contexte D (de type tel que précité en relation avec la première entité 26), par exemple acquises par le module d'acquisition 16, et à fournir une prévision de capacité simulée Pc₂ à l'entité 30 de détermination d'éléments d'aide à la négociation.

Similairement, l'entité 62 de simulation d'au moins un autre agent d'opération aérienne non représenté par ledit deuxième jumeau numérique simule le comportement des agents d'opération aérienne (i.e. compagnies aériennes) qui ne sont pas connectés au dispositif 10 d'aide à la planification et à la négociation dynamique de plan(s) de vol d'aéronef(s) mais qui participent à la demande d'intérêt des ANSPs connectés via ledit premier jumeau numérique. Pour ce faire, l'entité 62 de simulation prend en entrée les opérations habituelles des agents d'opération aérienne (i.e. compagnies aériennes) qui ne sont pas connectés au dispositif 10 d'aide à la planification, et prédit la charge que ces opérations auront sur le secteur.

L'entité 62 de simulation d'au moins un autre agent d'opération aérienne non représenté par ledit deuxième jumeau numérique est en outre propre à compléter les prévisions de demandes simulées au moyen de données de contexte D (de type tel que précité en relation avec la première entité 26), par exemple acquises par le module d'acquisition 16, et à fournir une prévision de demande simulée Pd₂ à l'entité 30 de détermination d'éléments d'aide à la négociation.

Quel que soit le mode de négociation mis en œuvre, à savoir basique, sollicitée ou autonome, son implémentation dépend de la connaissance de la situation et ainsi des données disponibles.

La figure 2 est une représentation 70 au cours du temps des interactions, de machine à machine, du dispositif électronique 10 d'aide à la planification et à la négociation dynamique de plan(s) de vol d'aéronef(s) selon la présente invention, avec le premier jumeau numérique 12 représentatif d'au moins un prestataire de services de navigation aérienne, et avec le deuxième jumeau numérique 14 représentatif d'au moins un agent d'opération aérienne.

Comme illustré par la figure 2, le dispositif électronique 10 d'aide à la planification et à la négociation dynamique de plan(s) de vol d'aéronef(s) selon la présente invention se place au milieu (i.e. au centre, en intermédiaire) d'un système à deux « pôles » 12 et 14. Il s'agit d'un outil d'aide à la planification et de négociation automatique lors de cette phase.

Plusieurs phases temporelles 72, 74, 76, 78 et 80 sont représentées, à savoir une phase stratégique 72 débutant environ 6 mois avant un vol donné jusqu'à une semaine avant ledit vol, suivie d'une phase pré-tactique 74 débutant une semaine avant ledit vol jusqu'à 1 jour avant ledit vol et comprenant notamment un instant 75 correspondant à un instant entre 3 et 2 jours avant ledit vol, suivie d'une phase tactique 76 débutant un jour avant ledit vol jusqu'audit vol et comprenant un instant 77 entre 8 et 2h avant ledit vol, ledit vol en tant que tel étant représenté par la phase 78, et suivi d'une phase 80 post-vol.

En parallèle des phases temporelles précitées, l'activité d'un agent d'opération aérienne, représenté par le deuxième jumeau numérique 14, comprend deux périodes A et B correspondant respectivement à l'établissement du programme A des vols, suivi de l'établissement B du plan dudit vol 78.

Egalement en parallèle des phases temporelles précitées, l'activité d'un prestataire de services de navigation aérienne ANSP, représenté par le premier jumeau numérique 12, comprend trois phases successives C, D et E, respectivement de gestion C de capacité, de gestion D de flux et de gestion E de vol.

La figure 2 illustre, comment au cours du temps, le dispositif électronique 10 d'aide à la planification et à la négociation dynamique de plan(s) de vol d'aéronef(s) selon la présente invention interagit avec le premier jumeau numérique 12 représentatif d'au moins un prestataire de services de navigation aérienne, et avec le deuxième jumeau numérique 14 représentatif d'au moins un agent d'opération aérienne.

Pour ce faire, le dispositif électronique 10 d'aide à la planification et à la négociation dynamique de plan(s) de vol d'aéronef(s) selon la présente invention reçoit tout d'abord en entrée des données 82 correspondant aux données de contexte précédemment décrites, à savoir notamment des données historiques, des données météo qui s'affinent au fur et à mesure qu'on s'approche du jour des opérations, les informations fournies par les ANSP, les évènements prévus (compétitions sportives, événements climatiques majeurs) etc....

Lors de la phase stratégique 72, le dispositif électronique 10 d'aide à la planification et à la négociation dynamique de plan(s) de vol d'aéronef(s) selon la présente invention reçoit de la part du deuxième jumeau numérique 14 représentatif d'au moins un agent d'opération aérienne 84, un prototype de route(s) 86 comprenant un programme des vols, au moins une route de compagnie aérienne (i.e. route catalogue d'une compagnie aérienne), au moins un créneau horaire (de l'anglais *slot)* donné audit au moins un agent d'opération aérienne, au moins une intention dudit au moins un agent d'opération aérienne (i.e. priorité d'optimisation de vol, minimisation du volume de carburant embarqué, et/ou encore minimisation du temps de vol).

Lors de cette même phase stratégique 72, le dispositif électronique 10 d'aide à la planification et à la négociation dynamique de plan(s) de vol d'aéronef(s) selon la présente invention reçoit également de la part d'au moins un prestataire de services de navigation aérienne ANSP 88, tel qu'un gestionnaire d'espace aérien ou une unité de gestion des flux de trafic, via ledit premier jumeau numérique 12, un prototype de trafic 90 comprenant des contraintes ANSP propre au secteur, des données historiques ANSP, un ensemble d'informations utiles pour les contrôleurs ou les pilotes concernant l'état des espaces aériens tel que les informations du portail d'Eurocontrol NOP (de l'anglais *Network Operations Portal*)*.*

Le dispositif électronique 10 d'aide à la planification et à la négociation dynamique de plan(s) de vol d'aéronef(s) selon la présente invention utilise l'ensemble des entrées 82, 86 et 90 précitées reçues lors de la phase stratégique 72 pour fournir automatiquement, lors de la phase pré-tactique 74, d'une part des prédictions 92 de route(s) la ou les plus probables à approuver lors de la période 94 par un opérateur 96 de centre de contrôle des opérations OCC (de l'anglais *Operations Control Center*)*,* et d'autre part des prédictions de trafic 98.

Les prédictions 92 de route(s) les plus probables qu'au moins une compagnie aérienne va emprunter pour les vols à venir respectent les contraintes ATC et peuvent servir de base non juridique à la création d'un plan de vol.

Une telle vue complète en termes de routes et trafic est générée en phase de planification (vols, routes, intentions des compagnies aériennes), avec une précision croissante à l'approche de la date du vol. A cela s'ajoute, une prédiction des points chauds anticipés sur le secteur à partir des données et de la prédiction de trafic. Les ANSP peuvent s'en servir pour planifier leur charge de travail et aussi simuler des modifications de contraintes, observer l'impact de cette modification, et ainsi proposer des modifications locales de contrainte pour fluidifier le trafic. Ces modifications sont automatiquement transférées aux agents d'opération aérienne et permet de générer de nouvelles routes de vol optimisées.

Lors de la phase tactique 76, le dispositif électronique 10 d'aide à la planification et à la négociation dynamique de plan(s) de vol d'aéronef(s) reçoit d'au moins un agent 100 d'opération aérienne (i.e. également appelé dispatcher de compagnie aérienne) au moins un plan de vol 102, puis lors de la phase de vol 78, le dispositif électronique 10 d'aide à la planification et à la négociation dynamique de plan(s) de vol d'aéronef(s) transmet à un pilote 104, via le deuxième jumeau numérique 14, une proposition de route 106, et transmet, via le deuxième jumeau numérique 12, à un contrôleur aérien ATCO 108 également ladite proposition de route 110.

A noter qu'il est difficile de proposer une route sans connaitre un ensemble de paramètres sous-jacents. Une approche fondée sur les données (de l'anglais *« data-driven »*) qui, à partir des données 86 historiques de programme de vol (de l'anglais *flight schedule*)*,* telles que la paire formée de l'aéroport de départ et d'arrivée d'un vol (de l'anglais *city pair*)*,* la compagnie aérienne opérant le vol, le type d'aéronef, la date du vol, l'heure de départ bloc EOBT (de l'anglais *Estimated Off Block Time*)*,* permet d'estimer le plan de vol, i une route possible, caractérisé par l'élément appelé champ 15 ICAO. Une telle approche mêle ingénierie des caractéristiques (de l'anglais *feature engineering*) et entrainement de modèle d'apprentissage machine.

Plus précisément, lors de la phase d'inférence, la fonctionnalité d'estimation de la route (élément 15 du plan de vol de l'OACI) exploite les données historiques de programmes de vol (la paire formée de l'aéroport de départ et d'arrivée d'un vol (de l'anglais *city pair*)*,* la compagnie aérienne, le type d'aéronef, la date, l'heure estimée de repoussage EOBT de l'anglais *estimated off block time*))*,* éventuellement enrichies par des informations complémentaires (météo, distance, coût, niveau de vol optimal, etc.).

Ces données sont soumises à une phase d'ingénierie des caractéristiques (de l'anglais *feature engineering*) afin d'extraire des indicateurs (i.e. caractéristiques (de l'anglais *features*)) pertinents (par exemple, un nombre de segments directs, une fréquence d'utilisation de certaines routes, des contraintes réglementaires).

Un modèle d'apprentissage machine (par exemple de type « forêt aléatoire » (de l'anglais *random forest*)*,* de type amplification du gradient (de l'anglais *gradient boosting*) tel que XGBoost^{®} ou encore un modèle de type grand modèle linguistique LLM (de l'anglais *Large Language Model*) est ensuite entraîné pour prédire, en fonction de ces caractéristiques, la route la plus adaptée au contexte opérationnel.

Enfin, un module de validation (par exemple l'outil « constraints checker^{®} ») est propre à être utilisé pour vérifier la conformité de la route proposée aux réglementations et aux contraintes du gestionnaire de réseau, assurant ainsi une recommandation à la fois réaliste et optimisée.

A titre d'alternative, une autre approche est propre à être basée sur du regroupement (de l'anglais *clustering*) pour caractériser les habitudes de la compagnie aérienne considérée.

Un centre opérationnel équipé du dispositif électronique 10 d'aide à la planification et à la négociation dynamique de plan(s) de vol d'aéronef(s) selon la présente invention, fournit à au moins un ANSP les contraintes (capacité, plafonds de niveau) pour ses secteurs en prévision, assurant une continuité entre la phase amont et le jour des opérations, créant une sorte de plan de vol préliminaire.

À l'approche du jour des opérations, le dispositif électronique 10 d'aide à la planification et à la négociation dynamique de plan(s) de vol d'aéronef(s) selon la présente invention effectue une vérification automatique des plans de vol reçus.

Si le plan de vol est valide, le dispositif électronique 10 attend une validation concrète du contrôleur. Si le plan de vol n'est pas valide, des alternatives fiables pour le secteur sont proposées aux compagnies aériennes sans travail supplémentaire pour les ANSPs.

Côté agent d'opération aérienne, le dispositif électronique 10 d'aide à la planification et à la négociation dynamique de plan(s) de vol d'aéronef(s) selon la présente invention gère donc de manière complète le catalogue de routes aériennes, depuis la planification à long terme jusqu'au jour des opérations. L'agent d'opération aérienne (i.e. également appelé dispatcher de compagnie aérienne) est assuré que les routes et trajectoires à venir sont optimisées et actualisées de manière automatiques et conformes aux contraintes. Pour se faire, le dispositif électronique 10 se base sur les données historiques et les données météos et ANSP déjà disponibles.

Le dispositif électronique 10 va prendre en compte les intentions et préférences de la ou les compagnies aériennes représentées par le jumeau numérique 14 pour formuler la route de vol préférentielle dans le contexte courant. Le dispositif électronique 10 réalise don une négociation automatique avec l'équivalent numérique 12 de l'ANSP pour sortir la route préférentielle adaptée aux contraintes ATC en vigueur.

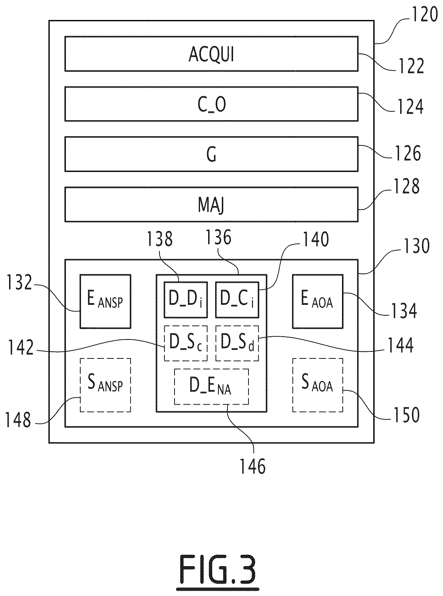

Le fonctionnement du dispositif électronique 10 d'aide à la planification et à la négociation dynamique de plan(s) de vol d'aéronef(s) va maintenant être décrit en référence à la figure 3 qui illustre schématiquement un exemple de mise en œuvre d'un procédé 120 d'aide à la planification et à la négociation dynamique de plan(s) de vol d'aéronef(s), par connexion, de machine à machine, avec le premier jumeau numérique 12 représentatif d'au moins un prestataire de services de navigation aérienne, et avec le deuxième jumeau numérique 14 représentatif d'au moins un agent d'opération aérienne.

Le procédé d'aide à la planification et à la négociation dynamique de plan(s) de vol d'aéronef(s) 120 est mis en œuvre par le dispositif 10 électronique d'aide à la planification et à la négociation dynamique de plan(s) de vol précédemment décrit en relation avec les figures 1 et 2.

Le procédé d'aide à la planification et à la négociation dynamique de plan(s) de vol d'aéronef(s) 120 est un procédé itératif et comprend au moins une itération des étapes 122, 124, 126, 128 et 130 décrites ci-après.

En effet, la négociation selon la présente invention se fait, en permanence, de manière automatique, et prend en compte l'actualisation des contraintes, des intentions des compagnies aériennes, des données météo, etc.

Chaque itération du procédé 120 d'aide à la planification et à la négociation dynamique de plan(s) de vol d'aéronef(s) comprend tout d'abord une étape 122 d'acquisition ACQUI (i.e. de collecte), analyse et/ou mise à jour de données, provenant d'une pluralité de sources distinctes comprenant au moins lesdits jumeaux numériques, lesdites données étant propres à avoir un impact sur la planification et la négociation de plan(s) de vol.

De telles données correspondent notamment à des historiques de vol, aux portails de gestion aérienne et aux intentions des acteurs que ce soient les acteurs prestataires de services de navigation aérienne ou les agent d'opération aérienne côté compagnie aérienne.

L'étape 122 est suivie d'une étape 124 de création et d'optimisation C_O de routes aéronautiques compatibles avec les contraintes de contrôle de trafic aérien associées auxdites données.

Ensuite, le procédé 120 d'aide à la planification et à la négociation dynamique de plan(s) de vol d'aéronef(s) comprend une étape 126 de génération G, à l'échelle mondiale, d'au moins une prédiction de trafic aérien à partir desdites routes aéronautiques.

Puis le procédé d'aide à la planification et à la négociation dynamique de plan(s) de vol d'aéronef(s) comprend une étape 128 de mise à jour MAJ desdites routes aéronautiques et de ladite au moins une prédiction de trafic aérien, dès qu'au moins une nouvelle donnée est acquise ou dès qu'au moins une donnée est mise à jour.

Enfin, l'itération courante comprends une étape 130 d'intervention (i.e. d'intervention électronique), en phase de planification de plan(s) de vol, dans une négociation (i.e. une négociation électronique) de plan(s) de vol entre lesdits jumeaux numériques, en utilisant ladite prédiction de trafic aérien.

En complément optionnel, l'étape 130 d'intervention (i.e. d'intervention électronique), en phase de planification de plan(s) de vol comprend les sous-étapes décrites ci-après.

L'étape 130 d'intervention comprend notamment une sous-étape 132 E_{ANSP} d'interaction avec le premier jumeau numérique représentatif d'au moins un prestataire de services de navigation aérienne, et une sous-étape 134 E_{AOA} d'interaction avec le deuxième jumeau numérique représentatif d'au moins un agent d'opération aérienne.

De plus, selon ce complément optionnel, l'étape 130 d'intervention comprend en outre une sous-étape 136 de détermination de demandes et capacités d'intérêt.

Plus précisément, la sous-étape 136 comprend une sous-sous-étape 138 de détermination D_Di, pour chaque prestataire de services de navigation aérienne, d'une information de demande d'intérêt représentative de tous les vols traversant une de ses zones de contrôle, et une sous-sous-étape 140 de détermination D_Ci, pour chaque agent d'opération aérienne, une information de capacité d'intérêt regroupant les capacités des zones traversées, par un ou plusieurs vols.

En option (représentée en pointillés) de ce complément optionnel, la sous-étape 136 comprend également une sous-sous-étape 142 de détermination D_S_{c}, par recherche dans une base de données de situation(s) similaire(s) à la situation courante, pour chaque prestataire de services de navigation aérienne, d'une solution de capacité représentative de la capacité permettant d'absorber au mieux la demande d'intérêt. Une solution de capacité correspond par exemple à un ensemble de contraintes de réacheminement (de l'anglais *rerouting*)*.*

Selon cette même option, la sous-étape 136 comprend également une sous-sous-étape 144 de détermination D_S_{d}, pour chaque agent d'opération aérienne, une solution de demande proposant au moins un vol compatible avec la capacité d'intérêt, en utilisant un algorithme prédéterminé de recherche de chemin et une pondération prédéterminée basée sur au moins une intention de mise en œuvre de vol dudit agent d'opération aérienne. Une solution de demande correspond à un réacheminement (de l'anglais *rerouting*) compatible avec des zones interdites le long de la route considérée.

En complément facultatif, la sous-étape 136 comprend également une sous-sous-étape 146 de détermination D_E_{NA} d'éléments configurés pour rendre la négociation autonome en appliquant un ensemble de règles prédéterminées de traitement de ladite solution de capacité et/ou de ladite solution de demande proposée(s).

Selon une autre option complémentaire, l'étape 130 d'intervention comprend également une sous-étape 148 de simulation S_{ANSP} d'au moins un autre prestataire de services de navigation aérienne non représenté par ledit premier jumeau numérique tout en participant à ladite capacité d'intérêt, et une sous-étape 150 de simulation S_{AOA} d'au moins un autre agent d'opération aérienne non représenté par ledit deuxième jumeau numérique tout en participant à ladite demande d'intérêt.

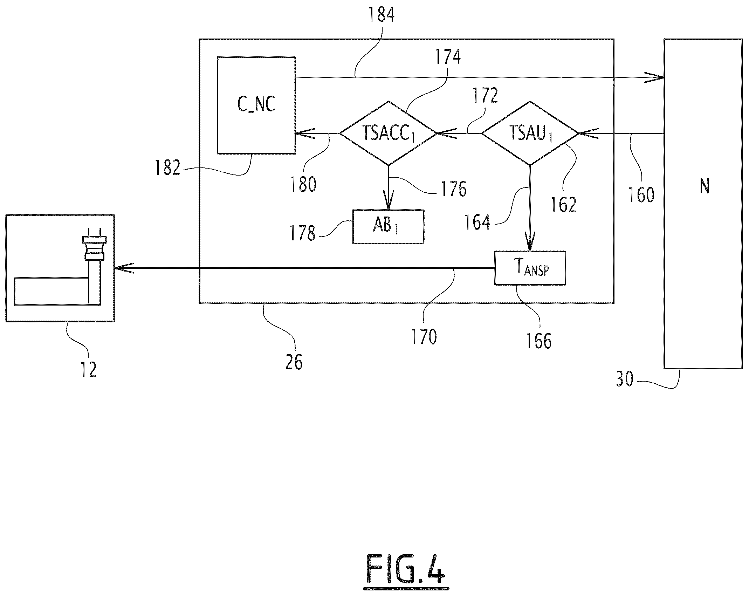

La figure 4 illustre des étapes optionnelles du procédé 120 d'aide à la planification et à la négociation dynamique de plan(s) de vol d'aéronef(s) de la figure 3, selon un mode de négociation dite autonome, dans le cas de l'établissement d'une réponse autonome à une solution (i.e. optimisation) de capacité 160 proposée par l'entité 30 de détermination d'éléments d'aide à la négociation N.

Les étapes relatives à l'établissement d'une réponse autonome sont notamment prises en charge par la première entité 26 d'interaction (également appelée agent ANSP) avec le premier jumeau numérique 12 représentatif d'au moins un prestataire de services de navigation aérienne, précédemment introduite en relation avec la figure 1.

L'établissement d'une réponse autonome comprend tout d'abord une étape 162 de test TSAU₁, selon laquelle la première entité 26 d'interaction teste si ladite solution de capacité 160 proposée par l'entité 30 de détermination d'éléments d'aide à la négociation N peut être traitée automatiquement ou non.

Dans la négative, selon la flèche 164, la première entité 26 d'interaction met en œuvre une étape 166 de transmission T_{ANSP} de ladite solution de capacité, selon la flèche 170 au premier jumeau numérique 12 représentatif d'au moins un prestataire de services de navigation aérienne ANSP.

Au contraire dans l'affirmative, selon la flèche 172, la première entité 26 d'interaction met en œuvre une deuxième étape 174 de test TSACC₁ déterminant si ladite solution de capacité 160 peut être acceptée ou non.

Dans la négative, selon la flèche 176, la première entité 26 d'interaction met en œuvre une étape 178 d'abandon AB₁ de ladite solution de capacité. Dans l'affirmative, selon la flèche 180, la première entité 26 d'interaction met en œuvre une étape 182 de calcul C_NC d'une nouvelle capacité (i.e. mise à jour de la capacité) retransmise selon la flèche 184 à l'entité 30 de détermination d'éléments d'aide à la négociation N, pour faire avancer la négociation.

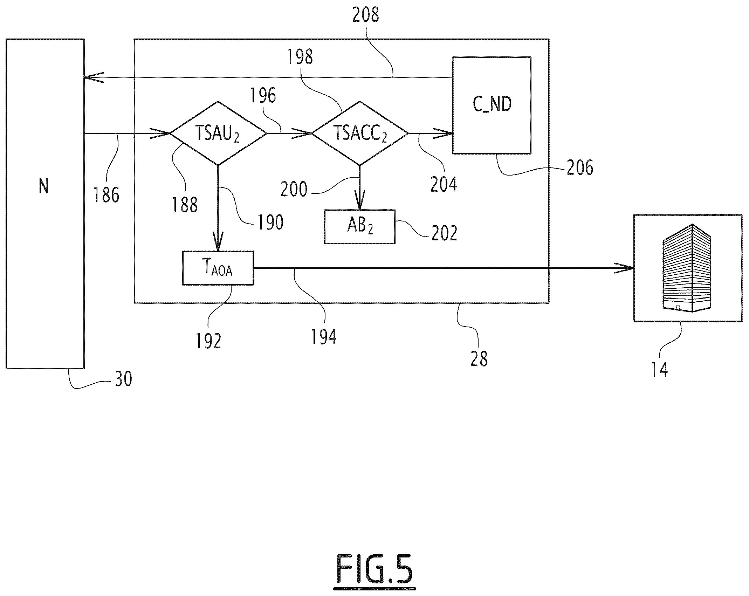

La figure 5 illustre des étapes optionnelles du procédé 120 d'aide à la planification et à la négociation dynamique de plan(s) de vol d'aéronef(s) de la figure 3, selon un mode de négociation dite autonome, dans le cas de l'établissement d'une réponse autonome à une solution (i.e. optimisation) de capacité 160 proposée par l'entité 30 de détermination d'éléments d'aide à la négociation N.

La figure 5 illustre des étapes optionnelles du procédé 120 d'aide à la planification et à la négociation dynamique de plan(s) de vol d'aéronef(s) de la figure 3, selon un mode de négociation dite autonome, dans le cas de l'établissement d'une réponse autonome à une solution (i.e. optimisation) de demande 186 proposée par l'entité 30 de détermination d'éléments d'aide à la négociation N.

Les étapes relatives à l'établissement d'une réponse autonome sont notamment prises en charge par la deuxième entité 28 d'interaction (également appelée agent compagnie aérienne) avec le deuxième jumeau numérique 14 représentatif d'au moins un agent d'opération aérienne, précédemment introduite en relation avec la figure 1.

L'établissement d'une telle réponse autonome comprend tout d'abord une étape 188 de test TSAU₂, selon laquelle la deuxième entité 28 d'interaction teste si ladite solution de de demande 186 proposée par l'entité 30 de détermination d'éléments d'aide à la négociation N peut être traitée automatiquement ou non.

Dans la négative, selon la flèche 190, la deuxième entité 28 d'interaction met en œuvre une étape 192 de transmission T_{AOA} de ladite solution de demande, selon la flèche 194 au deuxième jumeau numérique 14 représentatif d'au moins un agent d'opération aérienne.

Au contraire dans l'affirmative, selon la flèche 196, la deuxième entité 28 d'interaction met en œuvre une deuxième étape 198 de test TSACC₂ déterminant si ladite solution de de demande 186 peut être acceptée ou non.

Dans la négative, selon la flèche 200, la deuxième entité 28 d'interaction met en œuvre une étape 202 d'abandon AB₂ de ladite solution de demande. Dans l'affirmative, selon la flèche 204, la deuxième entité 28 d'interaction met en œuvre une étape 206 de calcul C_ND d'une nouvelle demande (i.e. mise à jour de la demande) retransmise selon la flèche 208 à l'entité 30 de détermination d'éléments d'aide à la négociation N, pour faire avancer la négociation.

Autrement dit, pour le mode de négociation autonome, les entités d'interaction, à savoir l'agents ANSP 26 et l'agent compagnie aérienne 28, sont configurés pour prendre en charge la négociation, et répondre, de manière autonome, aux optimisations 160 et 186 proposées par l'entité 30 de détermination d'éléments d'aide à la négociation N en utilisant notamment une configuration prédéterminée qui définit :
- les conditions dans lesquelles une optimisation 160 ou 186 peut être traitée automatiquement (i.e. de manière autonome) par l'agent 26 ou 28, ou dans le cas contraire, est présentée directement à l'utilisateur ANSP ou compagnie aérienne via leur jumeau numérique 12 ou 14 respectivement ;
- les conditions dans lesquelles l'optimisation traitée par l'agent est acceptée ou refusée.
- et si une optimisation 160 ou 186 est acceptée (selon les flèches précitées 180 ou 204), la mise à jour automatique de la demande ou de la capacité vers l'entité 30 de détermination d'éléments d'aide à la négociation N.

Une telle configuration est définie par les utilisateurs chez les prestataires de services de navigation aérienne ANSPs ou les agents d'opération aérienne (i.e. également appelé dispatcher de compagnie aérienne), et à tout instant ces utilisateurs peuvent agir sur ladite configuration et par conséquent sur le fonctionnement du dispositif 10 d'aide à la planification et à la négociation dynamique de plan(s) de vol d'aéronef(s), Par exemple, un agent d'opération aérienne (i.e. également appelé dispatcher de compagnie aérienne) peut ajouter de nouvelles intentions, préciser les routes qu'il veut emprunter afin de nourrir la négociation.

Cette configuration définit par exemple dans quelle plage horaire, une optimisation (i.e. solution de demande ou de capacité) peut être acceptée, quels types d'optimisations peuvent être acceptés ou traités en autonome. Par exemple, pour les prestataires de services de navigation aérienne ANSPs, l'élimination de certaines contraintes peut être interdite ou nécessite l'examen du gestionnaire des flux de trafic aérien FMP (de l'anglais Flow Management Position).

En outre, les entités d'interaction, à savoir l'agents ANSP 26 et l'agent compagnie aérienne 28, peuvent adapter en autonomie leurs capacités ou demandes en fonction de l'évolution de la situation. Par exemple, un agent ANSP 26 peut enlever une contrainte si la demande d'intérêt dans son secteur descend en dessous d'un seuil prédéterminé. De même, un agent compagnie aérienne 28 peut décider un réacheminement (de l'anglais *rerouting*) si les contraintes d'intérêt sont trop importantes.

Un tel mécanisme se basant sur une configuration prédéterminée spécifiée par les utilisateurs chez les prestataires de services de navigation aérienne ANSPs ou les agents d'opération aérienne (i.e. également appelé dispatcher de compagnie aérienne) permet des optimisations locales.

Comme illustré précédemment en relation avec la figure 1, pour ce faire, un agent ANSP 26 utilise une base de données 48 de contraintes possibles sur sa zone d'intérêt et une base 50 de règles métiers propres aux ANSP. Les règles métiers permettent de décider en fonction de la demande quelles sont les contraintes possibles à appliquer. La base de données de contraintes et la base de règles sont configurées par l'ANSP via le jumeau numérique 12.

De même, comme illustré précédemment en relation avec la figure 1, pour ce faire, un agent compagnie aérienne 28 utilise une base de données 56 de routes possibles (le catalogue de routes) et une base 58 de règles métier propres aux compagnies aériennes. Les règles métiers permettent de décider les meilleures routes possibles en fonction de la capacité d'intérêt. La base de données de route et la base de règle sont configurées par la compagnie aérienne.

L'homme du métier comprendra que l'invention ne se limite pas aux modes de réalisation décrits, ni aux exemples particuliers de la description, les modes de réalisation et les variantes mentionnées ci-dessus étant propres à être combinés entre eux pour générer de nouveaux modes de réalisation de l'invention.

La présente invention permet ainsi, dans un contexte de planification et de négociation dynamique de plan(s) de vol, d'échanger de l'information contre de la prédictibilité, d'obtenir automatiquement, au plus tôt, des routes optimisées qui sont compatibles avec l'ensemble des contraintes, donc plus susceptibles d'être acceptées en l'état, et d'utiliser cette estimation pour lancer une négociation automatique entre les acteurs du trafic afin de l'optimiser et d'améliorer la prédictibilité du jour des opérations.

La présente invention permet un partage d'information et d'intention, global et évolutif même si imparfait entre le sol et le bord, avec une volonté de prendre en compte et de traiter de manière globale cette information. Ceci représente un avantage certain par rapport à d'autres initiatives de partage d'information et de centralisation de l'état de la technique qui restent souvent localisées à une région du monde.

La présente invention propose une négociation automatique machine à machine pour prétraiter les demandes et ne soumettre que celle ayant un haut potentiel d'acceptation, alors que les négociations actuellement proposées facilitent la négociation mais ne vont pas jusqu'à l'automatiser, et laissent une grosse charge de travail sur les différents acteurs de cette négociation qui doivent valider ou non toute les demandes faites sans prétraitement.

## Revendications

1. Dispositif (10) électronique d'aide à la planification et à la négociation dynamique de plan(s) de vol d'aéronef(s), par connexion, de machine à machine, avec un premier jumeau numérique (12) représentatif d'au moins un prestataire de services de navigation aérienne, et avec un deuxième jumeau numérique (14) représentatif d'au moins un agent d'opération aérienne, ledit dispositif (10) comprenant au moins :
- un module (16) d'acquisition, d'analyse et de mise à jour configuré pour acquérir, analyser et mettre à jour des données, provenant d'une pluralité de sources distinctes comprenant au moins lesdits jumeaux numériques, lesdites données étant propres à avoir un impact sur la planification et la négociation de plan(s) de vol ;
- un module (18) de création et d'optimisation configuré, à partir desdites données, pour créer et optimiser des routes aéronautiques compatibles avec les contraintes de contrôle de trafic aérien associées auxdites données ;
- un module (20) de génération configuré pour générer, à l'échelle mondiale, au moins une prédiction de trafic aérien à partir desdites routes aéronautiques ;
- un module (22) de mise à jour configuré pour mettre à jour lesdites routes aéronautiques et ladite au moins une prédiction de trafic aérien, dès qu'au moins une nouvelle donnée est acquise ou dès qu'au moins une donnée est mise à jour ;
- un module (24) de négociation configuré pour intervenir, en phase de planification de plan(s) de vol, dans une négociation de plan(s) de vol entre lesdits jumeaux numériques, en utilisant ladite prédiction de trafic aérien.

2. Dispositif (10) selon la revendication 1, dans lequel lesdites données comprennent des données fournies par lesdits jumeaux numériques et également des données de contexte de type appartenant au groupe comprenant au moins :
- des données de surveillances fournie par un système de surveillance coopératif pour le contrôle du trafic aérien ;
- des publications aéronautiques ;
- des données météorologiques ;
- des données d'évènements ;
- des données historiques.

3. Dispositif (10) selon la revendication 1 ou 2, dans lequel ledit module (24) de négociation comprend au moins :
- une première entité (26) d'interaction avec le premier jumeau numérique représentatif d'au moins un prestataire de services de navigation aérienne, au moins configurée pour recevoir au moins une information représentative d'une capacité dudit au moins un prestataire de services de navigation aérienne, ladite capacité étant définie pour chaque zone de contrôle de l'espace aérien associé audit au moins un prestataire de services de navigation aérienne et pour une période temporelle prédéterminée ;
- une deuxième entité (28) d'interaction avec le deuxième jumeau numérique représentatif d'au moins un agent d'opération aérienne, au moins configurée pour recevoir au moins une information représentative d'une demande dudit au moins un agent d'opération aérienne, ladite demande étant définie par les vols prévus ou en cours associés audit au moins un agent d'opération aérienne ;
- une entité (30) de détermination d'éléments d'aide à la négociation configurée au moins pour:
- déterminer, pour chaque prestataire de services de navigation aérienne, une information de demande d'intérêt représentative de tous les vols traversant une de ses zones de contrôle ;
- déterminer, pour chaque agent d'opération aérienne, une information de capacité d'intérêt regroupant les capacités des zones traversées.

4. Dispositif selon la revendication 3, dans lequel l'entité (30) de détermination est également configurée pour estimer l'évolution de la demande de trafic en utilisant :
- un filtrage (40) optimal appartenant au groupe comprenant :
- un filtrage de Kalman ;
- un filtrage particulaire ;
ou
- un apprentissage (42) machine prédéterminé.

5. Dispositif selon la revendication 3 ou 4, dans lequel ladite entité de détermination (30) d'éléments d'aide à la négociation est en outre configurée pour :
- déterminer, par recherche dans une base de données de situation(s) similaire(s) à la situation courante, pour chaque prestataire de services de navigation aérienne, une solution de capacité représentative de la capacité permettant d'absorber au mieux la demande d'intérêt ;
- déterminer, pour chaque agent d'opération aérienne, une solution de demande proposant au moins un vol compatible avec la capacité d'intérêt, en utilisant un algorithme prédéterminé de recherche de chemin et une pondération prédéterminée basée sur au moins une intention de mise en œuvre de vol dudit agent d'opération aérienne.

6. Dispositif (10) selon la revendication 5, dans lequel ledit module de négociation (24) est en outre configuré pour rendre la négociation autonome en appliquant un ensemble de règles prédéterminées de traitement de ladite solution de capacité et/ou de ladite solution de demande proposée(s).

7. Dispositif (10) selon la revendication 5 ou 6, dans lequel la solution de demande est déterminée en outre en utilisant un catalogue (56) de routes prédéterminé et une base (58) de règles métier propres aux compagnies aériennes, ledit catalogue et ladite base de règle métier étant préalablement configurés par ledit au moins un agent d'opération aérienne.

8. Dispositif (10) selon l'une quelconque des revendications 3 à 7, dans lequel ledit module de négociation (24) comprend en outre:
- une entité (60) de simulation d'au moins un autre prestataire de services de navigation aérienne non représenté par ledit premier jumeau numérique tout en participant à ladite capacité d'intérêt ;
- une entité (62) de simulation d'au moins un autre agent d'opération aérienne non représenté par ledit deuxième jumeau numérique tout en participant à ladite demande d'intérêt.

9. Procédé (120) d'aide à la planification et à la négociation dynamique de plan(s) de vol d'aéronef(s), par connexion, de machine à machine, avec un premier jumeau numérique représentatif d'au moins un prestataire de services de navigation aérienne, et avec un deuxième jumeau numérique représentatif d'au moins un agent d'opération aérienne, ledit procédé étant mis en œuvre par un dispositif électronique d'aide à la planification et à la négociation dynamique de plan(s) de vol,
ledit procédé comprenant au moins une itération des étapes suivantes :
- acquisition (122), analyse et/ou mise à jour de données, provenant d'une pluralité de sources distinctes comprenant au moins lesdits jumeaux numériques, lesdites données étant propres à avoir un impact sur la planification et la négociation de plan(s) de vol ;
- création et optimisation (124) de routes aéronautiques compatibles avec les contraintes de contrôle de trafic aérien associées auxdites données ;
- génération (126), à l'échelle mondiale, d'au moins une prédiction de trafic aérien à partir desdites routes aéronautiques ;
- mise à jour (128) desdites routes aéronautiques et de ladite au moins une prédiction de trafic aérien, dès qu'au moins une nouvelle donnée est acquise ou dès qu'au moins une donnée est mise à jour ;
- intervention (130), en phase de planification de plan(s) de vol, dans une négociation de plan(s) de vol entre lesdits jumeaux numériques, en utilisant ladite prédiction de trafic aérien.

10. Programme d'ordinateur comportant des instructions logicielles qui, lorsqu'elles sont exécutées par un ordinateur, mettent en œuvre un procédé d'aide à la planification et à la négociation dynamique de plan(s) de vol d'aéronef(s) selon la revendication précédente.

## Revendications modifiées

### Revendications modifiées conformément à la règle 137(2) CBE.

1. Dispositif (10) électronique d'aide à la planification et à la négociation dynamique de plan(s) de vol d'aéronef(s), par connexion, de machine à machine, avec un premier jumeau numérique (12) représentatif d'au moins un prestataire de services de navigation aérienne, et avec un deuxième jumeau numérique (14) représentatif d'au moins un agent d'opération aérienne, ledit dispositif (10) comprenant au moins :
- un module (16) d'acquisition, d'analyse et de mise à jour configuré pour acquérir, analyser et mettre à jour des données, provenant d'une pluralité de sources distinctes comprenant au moins lesdits premier et deuxième jumeaux numériques, lesdites données étant propres à avoir un impact sur la planification et la négociation de plan(s) de vol ;
- un module (18) de création et d'optimisation configuré, à partir desdites données, pour créer et optimiser des routes aéronautiques compatibles avec les contraintes de contrôle de trafic aérien associées auxdites données ;
- un module (20) de génération configuré pour générer, à l'échelle mondiale, au moins une prédiction de trafic aérien à partir desdites routes aéronautiques ;
- un module (22) de mise à jour configuré pour mettre à jour lesdites routes aéronautiques et ladite au moins une prédiction de trafic aérien, dès qu'au moins une nouvelle donnée est acquise ou dès qu'au moins une donnée est mise à jour ;
- un module (24) de négociation configuré pour intervenir, en phase de planification de plan(s) de vol, dans une négociation de plan(s) de vol entre lesdits premier et deuxième jumeaux numériques, en utilisant ladite prédiction de trafic aérien.

2. Dispositif (10) selon la revendication 1, dans lequel lesdites données comprennent des données fournies par lesdits premier et deuxième jumeaux numériques et également des données de contexte de type appartenant au groupe comprenant au moins :
- des données de surveillances fournie par un système de surveillance coopératif pour le contrôle du trafic aérien ;
- des publications aéronautiques ;
- des données météorologiques ;
- des données d'évènements ;
- des données historiques.

3. Dispositif (10) selon la revendication 1 ou 2, dans lequel ledit module (24) de négociation comprend au moins :
- une première entité (26) d'interaction avec le premier jumeau numérique représentatif d'au moins un prestataire de services de navigation aérienne, au moins configurée pour recevoir au moins une information représentative d'une capacité dudit au moins un prestataire de services de navigation aérienne, ladite capacité étant définie pour chaque zone de contrôle de l'espace aérien associé audit au moins un prestataire de services de navigation aérienne et pour une période temporelle prédéterminée ;
- une deuxième entité (28) d'interaction avec le deuxième jumeau numérique représentatif d'au moins un agent d'opération aérienne, au moins configurée pour recevoir au moins une information représentative d'une demande dudit au moins un agent d'opération aérienne, ladite demande étant définie par les vols prévus ou en cours associés audit au moins un agent d'opération aérienne ;
- une entité (30) de détermination d'éléments d'aide à la négociation configurée au moins pour:
- déterminer, pour chaque prestataire de services de navigation aérienne, une information de demande d'intérêt représentative de tous les vols traversant une de ses zones de contrôle ;
- déterminer, pour chaque agent d'opération aérienne, une information de capacité d'intérêt regroupant les capacités des zones traversées.

4. Dispositif selon la revendication 3, dans lequel l'entité (30) de détermination est également configurée pour estimer l'évolution de la demande de trafic en utilisant :
- un filtrage (40) optimal appartenant au groupe comprenant :
- un filtrage de Kalman ;
- un filtrage particulaire ;
ou
- un apprentissage (42) machine prédéterminé.

5. Dispositif selon la revendication 3 ou 4, dans lequel ladite entité de détermination (30) d'éléments d'aide à la négociation est en outre configurée pour :
- déterminer, par recherche dans une base de données de situation(s) similaire(s) à la situation courante, pour chaque prestataire de services de navigation aérienne, une solution de capacité représentative de la capacité permettant d'absorber au mieux la demande d'intérêt ;
- déterminer, pour chaque agent d'opération aérienne, une solution de demande proposant au moins un vol compatible avec la capacité d'intérêt, en utilisant un algorithme prédéterminé de recherche de chemin et une pondération prédéterminée basée sur au moins une intention de mise en œuvre de vol dudit agent d'opération aérienne.

6. Dispositif (10) selon la revendication 5, dans lequel ledit module de négociation (24) est en outre configuré pour rendre la négociation autonome en appliquant un ensemble de règles prédéterminées de traitement de ladite solution de capacité et/ou de ladite solution de demande proposée(s).

7. Dispositif (10) selon la revendication 5 ou 6, dans lequel la solution de demande est déterminée en outre en utilisant un catalogue (56) de routes prédéterminé et une base (58) de règles métier propres aux compagnies aériennes, ledit catalogue et ladite base de règle métier étant préalablement configurés par ledit au moins un agent d'opération aérienne.

8. Dispositif (10) selon l'une quelconque des revendications 3 à 7, dans lequel ledit module de négociation (24) comprend en outre:
- une entité (60) de simulation d'au moins un autre prestataire de services de navigation aérienne non représenté par ledit premier jumeau numérique tout en participant à ladite capacité d'intérêt ;
- une entité (62) de simulation d'au moins un autre agent d'opération aérienne non représenté par ledit deuxième jumeau numérique tout en participant à ladite demande d'intérêt.

9. Procédé (120) d'aide à la planification et à la négociation dynamique de plan(s) de vol d'aéronef(s), par connexion, de machine à machine, avec un premier jumeau numérique représentatif d'au moins un prestataire de services de navigation aérienne, et avec un deuxième jumeau numérique représentatif d'au moins un agent d'opération aérienne, ledit procédé étant mis en œuvre par un dispositif électronique d'aide à la planification et à la négociation dynamique des plans de vol,
ledit procédé comprenant au moins une itération des étapes suivantes :
- acquisition (122), analyse et/ou mise à jour de données, provenant d'une pluralité de sources distinctes comprenant au moins lesdits premier et deuxième jumeaux numériques, lesdites données étant propres à avoir un impact sur la planification et la négociation de plan(s) de vol ;
- création et optimisation (124) de routes aéronautiques compatibles avec les contraintes de contrôle de trafic aérien associées auxdites données ;
- génération (126), à l'échelle mondiale, d'au moins une prédiction de trafic aérien à partir desdites routes aéronautiques ;
- mise à jour (128) desdites routes aéronautiques et de ladite au moins une prédiction de trafic aérien, dès qu'au moins une nouvelle donnée est acquise ou dès qu'au moins une donnée est mise à jour ;
- intervention (130), en phase de planification de plan(s) de vol, dans une négociation de plan(s) de vol entre lesdits premier et deuxième jumeaux numériques, en utilisant ladite prédiction de trafic aérien.

10. Programme d'ordinateur comportant des instructions logicielles qui, lorsqu'elles sont exécutées par un ordinateur, mettent en œuvre un procédé d'aide à la planification et à la négociation dynamique de plan(s) de vol d'aéronef(s) selon la revendication précédente.
